# EUROPEAN PATENT APPLICATION

(11) **EP 4 796 787 A2**
(43) Date of publication of application: **26.08.2026**
(21) Application number: 26191181.2
(22) Date of filing: 23.05.2023
(51) Int. Cl.: F04B 49/06

(54) **VACUUM PUMP**

(30) Priority: 25.05.2022 US 202263345573 P
(62) Document number(s) of the earlier application(s) in accordance with Art. 76 EPC: 23174725.4 / 4 287 452
(71) Applicant: Milwaukee Electric Tool Corporation, Brookfield, WI 53005 (US)
(72) Inventor: PROSSER, Kyle T, JBER, AK 99506 (US)
(74) Representative: Forresters IP LLP

(57) **Abstract**

A battery pack powered device includes a housing including a battery pack interface configured to receive a battery pack, a first sensing circuit configured to detect a battery pack voltage of the battery pack, a second sensing circuit configured to detect a current from the battery pack, and a controller. The controller includes a processor and a memory. The controller is configured to receive a first signal from the first sensing circuit related to the battery pack voltage, receive a second signal from the second sensing circuit related to the current from the battery pack, determine a battery pack impedance based on the battery pack voltage and the current from the battery pack, determine a battery pack type of the battery pack based on the battery pack impedance, and set a voltage threshold for the battery pack based on the battery pack type.

## Description

### RELATED APPLICATIONS

This application claims the benefit of U.S. Provisional Patent Application No. 63/345,573, filed May 25, 2022, the entire content of which is hereby incorporated by reference.

### FIELD

Embodiments described herein relate to a pump, and more particularly to a vacuum pump.

### SUMMARY

Vacuum pumps may be used to remove or evacuate material, such as unwanted air, gas, and non-condensables (e.g., water vapor), from an external system (e.g., an air conditioning system, a refrigeration system, etc.). Vacuum pumps may be used to evacuate the external system before the system is charged with refrigerant or when the existing system is undergoing repair (e.g., the refrigerant is already recovered). The vacuum pump may be connected to high- and low-pressure sides of the external system via hoses and a manifold. During operation, the vacuum pump creates a low-pressure zone that draws the unwanted materials, such as air and non-condensables, out of the external system, which has a high pressure, and into the vacuum pump.

Embodiments described herein provide a device, such as a battery pack power device. Battery pack powered devices or vacuum pumps disclosed herein are connectable to an external system and configured to evacuate material from the external system. The vacuum pumps include a housing including a battery pack interface configured to receive a battery pack, a first sensing circuit configured to detect a battery pack voltage of the battery pack, a second sensing circuit configured to detect a current from the battery pack, and a controller. The controller includes a processor and a memory. The controller is configured to receive a first signal from the first sensing circuit related to the battery pack voltage, receive a second signal from the second sensing circuit related to the current from the battery pack, determine a battery pack impedance based on the battery pack voltage and the current from the battery pack, determine a battery pack type of the battery pack based on the battery pack impedance, and set a voltage threshold for the battery pack based on the battery pack type.

In some aspects, the battery pack powered device is operable to determine an amount of energy the battery pack discharges over a defined time period based on the battery pack voltage and the current from the battery pack, determine a change in voltage of the battery pack based on the battery pack voltage, and determine the battery pack type of the battery pack based on the battery pack impedance, the determined amount of energy, and/or the change in voltage.

In some aspects, the battery pack powered device is operable to perform a defined action based on the battery pack type, the voltage threshold, and/or the battery pack voltage.

In some aspects, the battery pack powered device is operable to determine the battery pack voltage is less than or equal to the voltage threshold, and modify an operating mode of the battery pack powered device resulting in an increase in a discharge time of the battery pack.

In some aspects, the battery pack powered device is operable to receive a user input indicating a selection of an operating mode, and control the battery pack powered device based on the battery pack type and the battery pack voltage.

In some aspects, the controller of the battery pack powered device is operable to reduce an operating speed of the battery powered device based on the operating mode.

In some aspects, the controller of the battery pack powered device is operable to control the battery powered device at a first operating speed for a first defined time period based on the operating mode, and control the battery powered device at a second operating speed for a second defined time period based on the operating mode.

In some aspects, the battery pack powered device is operable to control operation of one or more indicators of the battery powered device based on the battery pack type that is determined and the battery pack voltage.

Embodiments described herein provide methods of operating a battery pack powered device. The methods include receiving, by a controller from a first sensing circuit, a first signal related to a battery pack voltage of a battery pack of the battery pack powered device, receiving, by the controller from a second sensing circuit, a second signal related to a current from the battery pack, determining, by the controller, a battery pack impedance based on the battery pack voltage and the current from the battery pack, determining, by the controller, a battery pack type of the battery pack based on the battery pack impedance, and setting, by the controller, a voltage threshold for the battery pack based on the battery pack type.

In some aspects, the method further includes determining an amount of energy the battery pack discharges over a defined time period based on the battery pack voltage and the current from the battery pack, determining a change in voltage of the battery pack based on the battery pack voltage, and determining the battery pack type of the battery pack based on the battery pack impedance, the determined amount of energy, and/or the change in voltage.

In some aspects, the method further includes performing a defined action based on the battery pack type, the voltage threshold, and/or the battery pack voltage.

In some aspects, the method further includes determining the battery pack voltage is less than or equal to the voltage threshold, and modifying an operating mode of the battery pack powered device resulting in an increase in a discharge time of the battery pack.

In some aspects, the method further includes receiving a user input indicating a selection of an operating mode, and controlling the battery pack powered device based on the battery pack type and the battery pack voltage.

In some aspects, the method further includes reducing an operating speed of the battery powered device based on the operating mode.

In some aspects, the method further includes controlling the battery powered device at a first operating speed for a first defined time period based on the operating mode, and controlling the battery powered device at a second operating speed for a second defined time period based on the operating mode.

In some aspects, the method further includes controlling operation of one or more indicators of the battery powered device based on the battery pack type that is determined and the battery pack voltage.

Before any embodiments are explained in detail, it is to be understood that the embodiments are not limited in application to the details of the configurations and arrangements of components set forth in the following description or illustrated in the accompanying drawings. The embodiments are capable of being practiced or of being carried out in various ways. Also, it is to be understood that the phraseology and terminology used herein are for the purpose of description and should not be regarded as limiting. The use of "including," "comprising," or "having" and variations thereof are meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings.

In addition, it should be understood that embodiments may include hardware, software, and electronic components or modules that, for purposes of discussion, may be illustrated and described as if the majority of the components were implemented solely in hardware. However, one of ordinary skill in the art, and based on a reading of this detailed description, would recognize that, in at least one embodiment, the electronic-based aspects may be implemented in software (e.g., stored on non-transitory computer-readable medium) executable by one or more processing units, such as a microprocessor and/or application specific integrated circuits ("ASICs"). As such, it should be noted that a plurality of hardware and software based devices, as well as a plurality of different structural components, may be utilized to implement the embodiments. For example, "servers," "computing devices," "controllers," "processors," etc., described in the specification can include one or more processing units, one or more computer-readable medium modules, one or more input/output interfaces, and various connections (e.g., a system bus) connecting the components.

Relative terminology, such as, for example, "about," "approximately," "substantially," etc., used in connection with a quantity or condition would be understood by those of ordinary skill to be inclusive of the stated value and has the meaning dictated by the context (e.g., the term includes at least the degree of error associated with the measurement accuracy, tolerances [e.g., manufacturing, assembly, use, etc.] associated with the particular value, etc.). Such terminology should also be considered as disclosing the range defined by the absolute values of the two endpoints. For example, the expression "from about 2 to about 4" also discloses the range "from 2 to 4". The relative terminology may refer to plus or minus a percentage (e.g., 1%, 5%, 10%, or more) of an indicated value.

It should be understood that although certain drawings illustrate hardware and software located within particular devices, these depictions are for illustrative purposes only. Functionality described herein as being performed by one component may be performed by multiple components in a distributed manner. Likewise, functionality performed by multiple components may be consolidated and performed by a single component. In some embodiments, the illustrated components may be combined or divided into separate software, firmware and/or hardware. For example, instead of being located within and performed by a single electronic processor, logic and processing may be distributed among multiple electronic processors. Regardless of how they are combined or divided, hardware and software components may be located on the same computing device or may be distributed among different computing devices connected by one or more networks or other suitable communication links. Similarly, a component described as performing particular functionality may also perform additional functionality not described herein. For example, a device or structure that is "configured" in a certain way is configured in at least that way but may also be configured in ways that are not explicitly listed.

Other aspects of the embodiments will become apparent by consideration of the detailed description and accompanying drawings.

### BRIEF DESCRIPTION OF THE DRAWINGS

FIG. 1 is a left perspective view of a vacuum pump, according to embodiments described herein.
FIG. 2 is a right perspective view of the vacuum pump of FIG. 1.
FIG. 3 is a cross-sectional perspective view of the vacuum pump along line 3-3 of FIG. 1.
FIG. 4 is a cross-sectional plan view of the vacuum pump along line 4-4 of FIG. 1.
FIG. 5 illustrates a control system for the vacuum pump of FIG. 1, according to embodiments described herein.
FIG. 6 illustrates a wireless communication controller for the device of FIG. 1, according to embodiments described herein.
FIG. 7 illustrates a communication system for the vacuum pump of FIG. 1 and an external device, according to embodiments described herein.
FIG. 8 illustrates a user interface for the vacuum pump of FIG. 1 and/or the external device of FIG. 7, according to embodiments described herein.
FIG. 9 illustrates a circuit diagram for a switching module, according to embodiments described herein.
FIGS. 10A, 10B, 10C, and 10D illustrate circuit diagrams to demonstrate current flow in the circuit diagram of FIG. 9, according to embodiments described herein.
FIGS. 11A, 11B, and 11C illustrate a process for determining an impedance of a battery pack, according to embodiments described herein.
FIG. 12 illustrate a process for controlling the vacuum pump of FIG. 1, according to embodiments described herein.
FIG. 13 illustrate a process for controlling the vacuum pump of FIG. 1, according to embodiments described herein.
FIGS. 14A, 14B, and 14C illustrate a process for controlling the vacuum pump of FIG. 1, according to embodiments described herein.

### DETAILED DESCRIPTION

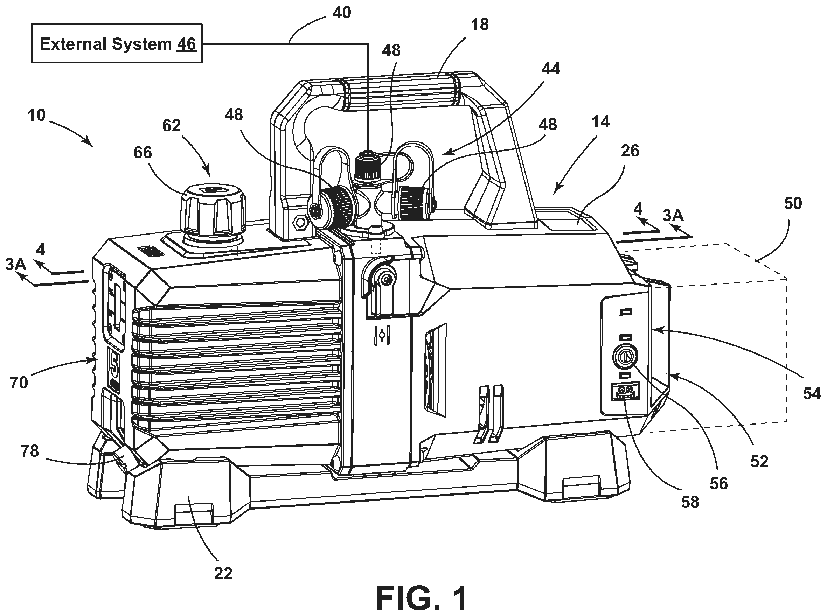

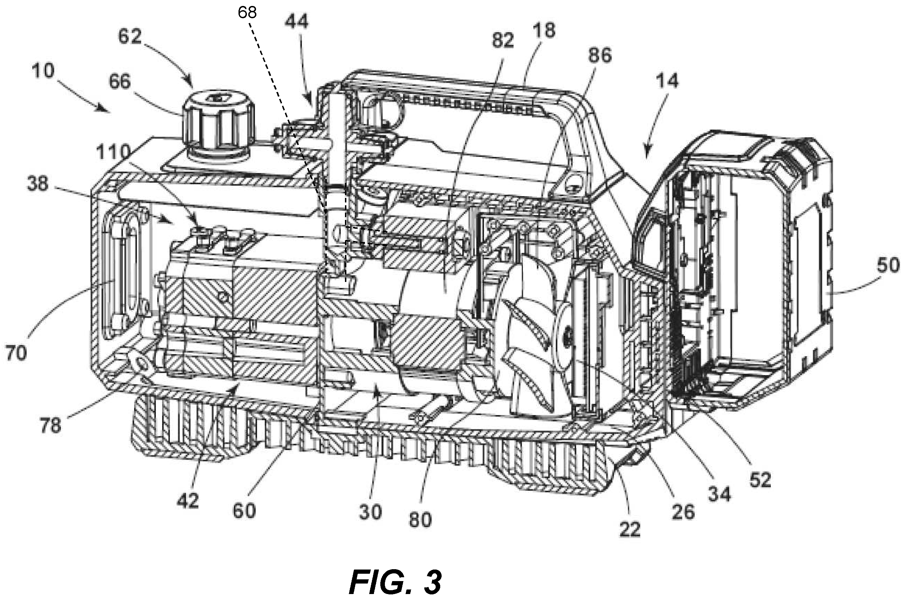

FIGS. 1-4 illustrate a vacuum pump 10 including a housing 14, a handle 18 coupled to an upper portion of the housing 14, and a base 22 coupled to a lower portion of the housing 14 to support the vacuum pump 10 relative to the ground. The housing 14 defines an internal cavity (see FIG. 3) that has a first chamber 26 that houses, protects, and/or conceals a motor assembly 30, an electronic control unit 34, and other electronic components. The internal cavity of the housing 14 also defines a second chamber (e.g., a compression chamber 38) that houses a pump assembly 42.

With reference to FIG. 1, an inlet 44 is positioned on an upper portion of the housing 14 and is in communication with the pump assembly 42. The inlet 44 is fluidly connected to a hose 40 that connects the vacuum pump 10 to an external system 46 (e.g., an air conditioning system, a refrigeration system, etc.). In the illustrated embodiment, the inlet 44 includes multiple connection ports 48 that are sized to connect to the hose 40 of the external system 46. For example, the connection ports 48 may have various sizes (e.g., ½ inch, ¼ inch, etc.).

A battery pack 50 is removably coupled to an end portion of the housing 14 via a battery receptacle 52. The battery pack 50 provides electrical current to the motor assembly 30 that drives the pump assembly 42 to remove or evacuate material such as air, gas, and non-condensables (e.g., water vapor) from the external system 46. The vacuum pump 10 includes a control panel 54 on a sidewall of the housing 14. In the illustrated embodiment, the control panel 54 includes a power switch 56 that selectively activates the vacuum pump 10 and a Universal Serial Bus ("USB") port 58. In some embodiments, an external display may be connected to the USB port 58 to display information related to the operation of the vacuum pump 10 (e.g., battery life remaining, micron gauge, etc.). In other embodiments, the control panel 54 may include a display (e.g., a liquid crystal display).

With reference to FIG. 3, the compression chamber 38 is sealed relative to the first chamber 26 via a partition wall 60 so the compression chamber 38 can hold lubrication fluid (e.g., oil). In the illustrated embodiment, the partition wall 60 defines a fluid pathway 68 that extends between the inlet 44 and the pump assembly 42. The lubrication fluid positioned within the compression chamber 38 is used to lubricate and cool the pump assembly 42 during operation of the vacuum pump 10.

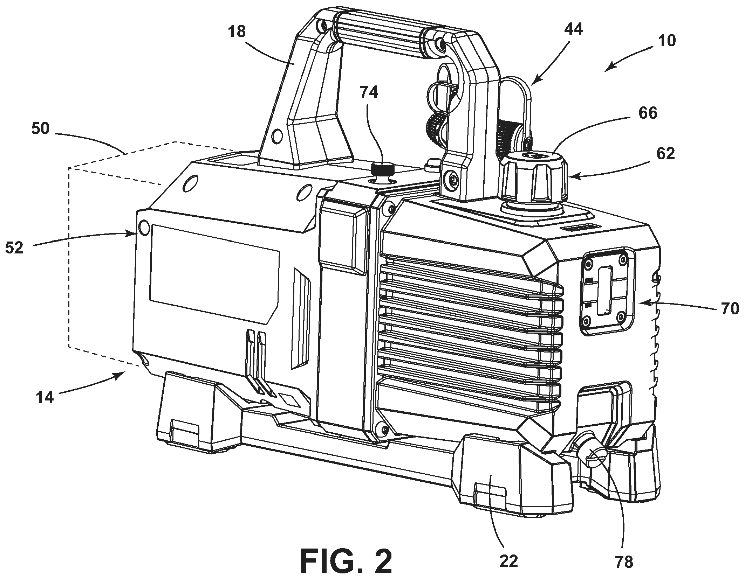

With reference to FIG. 2, the compression chamber 38 further includes a fluid port 62 having a removable cap 66, a fluid gauge 70 positioned on a sidewall of the housing 14, a release valve 74 positioned on the upper portion of the housing 14, and a fluid drain valve 78 positioned at the bottom of the compression chamber 38 adjacent the base 22. In the illustrated embodiment, a user may remove the removable cap 66 to fill the compression chamber 38 with lubrication fluid via the fluid port 62. The fluid port 62 and the removable cap 66 may also function as an exhaust during operation of the vacuum pump 10. The fluid gauge 70 may be transparent to allow a user to determine the amount of lubrication fluid that is held within the compression chamber 38. Also, the fluid drain valve 78 allows the user to drain the lubrication fluid from the compression chamber 38.

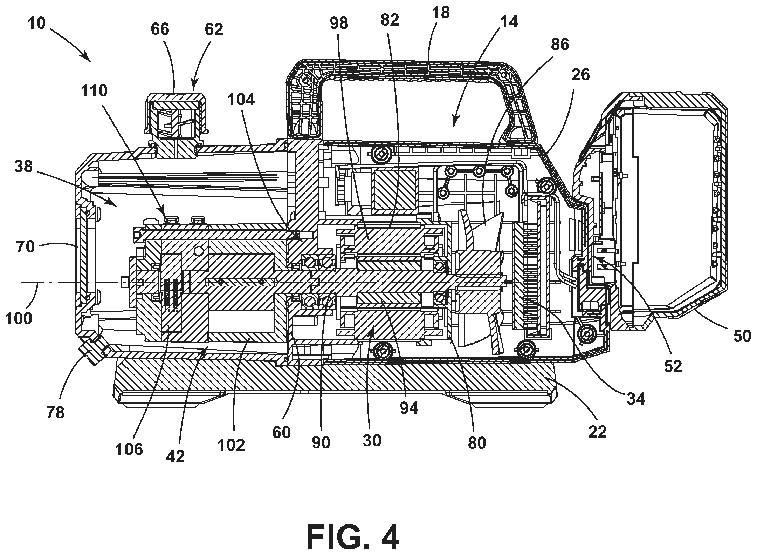

With reference to FIG. 4, the motor assembly 30 is positioned within the first chamber 26 and is coupled to the partition wall 60 via a support bracket 80. The motor assembly 30 includes a motor 82 and a fan 86 driven by the motor 82. In the illustrated embodiment, the motor 82 is a brushless direct current ("BLDC") motor that has a motor shaft 90 having a first end coupled to the fan 86 and a second end coupled to the pump assembly 42, a rotor 94 coupled to the motor shaft 90, and a stator 98 surrounding the rotor 94. During operation of the motor 82, an electrical current flows through coils of the stator 98 to produce a magnetic field around the rotor 94, which causes the motor shaft 90 to rotate about a drive axis 100 and drive the pump assembly 42. The fan 86 is positioned between the electronic control unit 34 and the motor assembly 30. The fan 86 removes heat from the electronic control unit 34 and provides air to the motor assembly 30 to prevent overheating of each of the electronic control unit 34 and the motor assembly 30. Although the motor 82 of the illustrated embodiment is a BLDC motor, in other embodiments, the motor 82 may alternatively be a brushed direct current motor or any other type of DC motor.

With reference to FIG. 4, the pump assembly 42 is a two-stage pump that has a first pump chamber 102 and a second pump chamber 106 in series with the first pump chamber 102. The first pump chamber 102 has a pump inlet 104 in communication with the fluid pathway 68. The first pump chamber 102 is in fluid communication with the second pump chamber 106. The second pump chamber 106 has a pump outlet 110 that releases the pressure from the pump assembly 42 to the compression chamber 38. Specifically, the pump chambers 102, 106 create low-pressure zones within the pump assembly 42, which draws material out of the external system 46 (see FIG. 1) and into the pump assembly 42. The evacuated material is transferred from the first pump chamber 102 to the second pump chamber 106, at which point the evacuated material is discharged into the compression chamber 38 via the second pump outlet 110. In the illustrated embodiment, the second pump outlet 110 includes a valve (e.g., a reed valve, etc.) that selectively releases the evacuated material into the compression chamber 38 before being released from the vacuum pump 10 through the exhaust (e.g., via the cap 66) of the compression chamber 38. Although the illustrated pump assembly 42 is a two-stage pump (e.g., has first and second pump chambers), in other embodiments, the pump assembly 42 may only include a single stage or chamber.

During operation, a user may attach the battery pack 50 to the battery receptacle 52 of the vacuum pump 10, and fluidly connect the external system 46 to the vacuum pump 10 via the inlet 44 (e.g., with the hose 40). The user may activate the vacuum pump 10 with the control panel 54 (e.g., by depressing the power switch 56) to activate the motor assembly 30 and begin evacuating material from the external system 46. When the vacuum pump 10 is activated, the first and second pump chambers 102, 106 create a low-pressure zone to evacuate material from the external system 46.

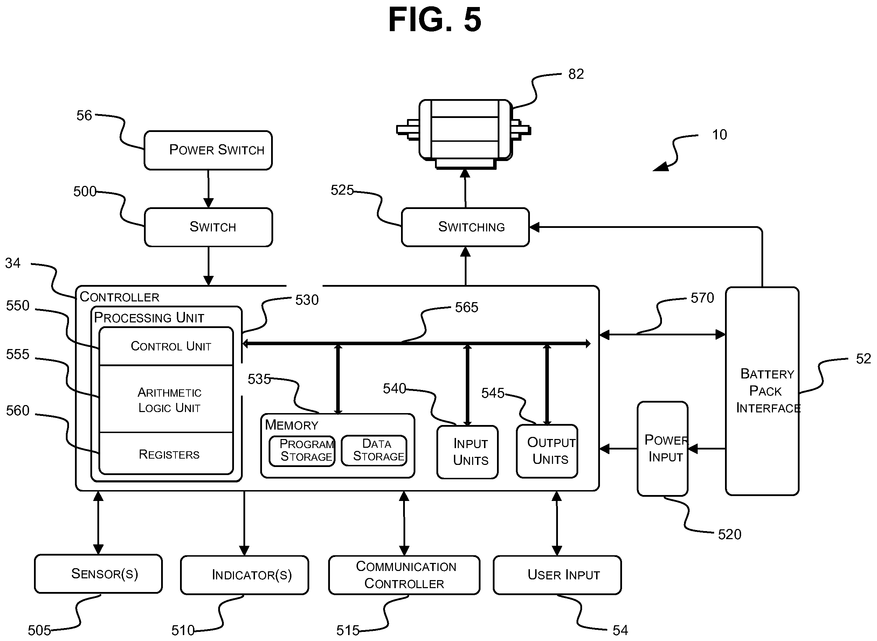

FIG. 5 illustrates a control system for the vacuum pump 10. The control system includes the electronic control unit 34. The electronic control unit 34 is electrically and/or communicatively connected to a variety of modules or components of the vacuum pump 10. For example, the illustrated electronic control unit 34 is electrically connected to the motor 82, the batter receptacle 52 (e.g., battery pack interface), a switch 500 (connected to the power switch 56), one or more sensors or sensing circuits 505, one or more indicators 510, the control panel 54 (e.g., a user input module), a wireless communication controller 515, a power input module 520, and a switching module 525 (e.g., including a plurality of switching FETs). The electronic control unit 34 includes combinations of hardware and software that are operable to, among other things, control the operation of the vacuum pump 10, monitor the operation of the vacuum pump 10, activate the one or more indicators 510 (e.g., an LED), etc.

The electronic control unit 34 includes a plurality of electrical and electronic components that provide power, operational control, and protection to the components and modules within the electronic control unit 34 and/or the vacuum pump 10. For example, the electronic control unit 34 includes, among other things, a processing unit 530 (e.g., a microprocessor, a microcontroller, an electronic processor, an electronic controller, or another suitable programmable device), a memory 535, input units 540, and output units 545. The processing unit 530 includes, among other things, a control unit 550, an arithmetic logic unit ("ALU") 555, and a plurality of registers 560 (shown as a group of registers in FIG. 5), and is implemented using a known computer architecture (e.g., a modified Harvard architecture, a von Neumann architecture, etc.). The processing unit 530, the memory 535, the input units 540, and the output units 545, as well as the various modules or circuits connected to the electronic control unit 34 are connected by one or more control and/or data buses (e.g., common bus 565). The control and/or data buses are shown generally in FIG. 5 for illustrative purposes. The use of one or more control and/or data buses for the interconnection between and communication among the various modules, circuits, and components would be known to a person skilled in the art in view of the invention described herein.

The memory 535 is a non-transitory computer readable medium and includes, for example, a program storage area and a data storage area. The program storage area and the data storage area can include combinations of different types of memory, such as a ROM, a RAM (e.g., DRAM, SDRAM, etc.), EEPROM, flash memory, a hard disk, an SD card, or other suitable magnetic, optical, physical, or electronic memory devices. The processing unit 530 is connected to the memory 535 and executes software instructions that are capable of being stored in a RAM of the memory 535 (e.g., during execution), a ROM of the memory 535 (e.g., on a generally permanent basis), or another non-transitory computer readable medium such as another memory or a disc. Software included in the implementation of the vacuum pump 10 can be stored in the memory 535 of the electronic control unit 34. The software includes, for example, firmware, one or more applications, program data, filters, rules, one or more program modules, and other executable instructions. The electronic control unit 34 is configured to retrieve from the memory 535 and execute, among other things, instructions related to the control processes and methods described herein. In other constructions, the electronic control unit 34 includes additional, fewer, or different components.

The battery receptacle or battery pack interface 52 includes a combination of mechanical components (e.g., rails, grooves, latches, etc.) and electrical components (e.g., one or more terminals) configured to and operable for interfacing (e.g., mechanically, electrically, and communicatively connecting) the vacuum pump 10 with a battery pack (e.g., the battery pack 50). For example, power provided by the battery pack 50 to the vacuum pump 10 is provided through the battery receptacle 52 to the power input module 520. The power input module 520 includes combinations of active and passive components to regulate or control the power received from the battery pack 50 prior to power being provided to the electronic control unit 34. The battery receptacle 52 also supplies power to the FET switching module 525 to provide power to the motor 82. The battery receptacle 52 also includes, for example, a communication line 570 for providing a communication line or link between the electronic control unit 34 and the battery pack 50.

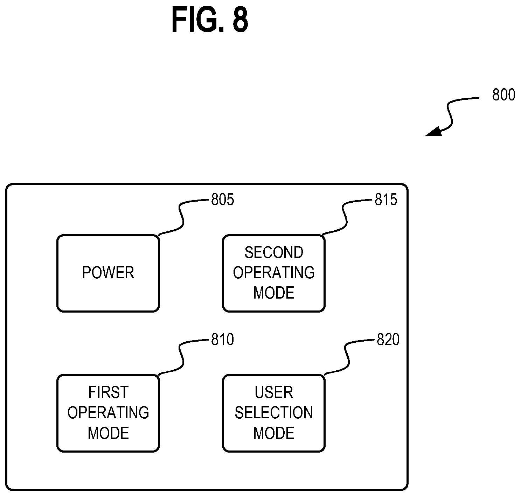

The indicators 510 include, for example, one or more light-emitting diodes ("LEDs") and/or audio signaling devices. The indicators 510 can be configured to display or indicate conditions of, or information associated with, the vacuum pump 10. For example, the indicators 510 are configured to indicate measured electrical characteristics of the vacuum pump 10, the status of the vacuum pump 10, etc. The control panel 54 is operably coupled to the electronic control unit 34 to, for example, select an operating mode (e.g., a boost mode of operation or an eco mode of operation), a torque and/or speed setting for the vacuum pump 10 (e.g., using torque and/or speed switches), etc. In some embodiments, the control panel 54 includes a combination of digital (see, e.g., user interface 800 of FIG. 8) and analog input or output devices required to achieve a desired level of operation for the vacuum pump 10, such as one or more knobs, one or more dials, one or more switches, one or more buttons, etc.

The electronic control unit 34 is configured to determine a battery pack type of the battery pack 50 of the vacuum pump 10. In some embodiments, the electronic control unit 34 sets a voltage threshold based on the battery pack type and controls the one or more indicators 510 using the voltage threshold. Additionally, the electronic control unit 34 is configured to control the operating speed of the vacuum pump 10 to reduce the amount of current drawn from the battery pack 50 based on a set voltage threshold associated with a determined battery pack type and/or user selected operating mode.

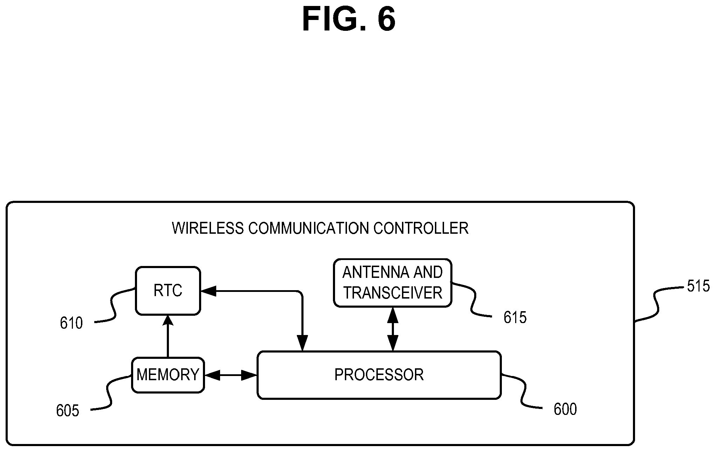

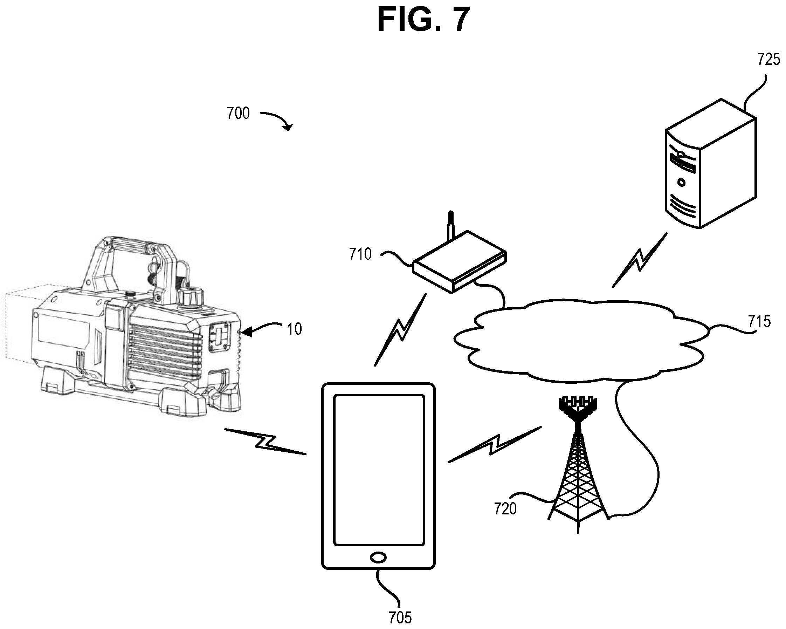

FIG. 5 provides an illustration of the wireless communication controller 515 that includes a processor 600, a memory 605, a real-time clock ("RTC") 610, and an antenna and transceiver 615, as shown in FIG. 6. The wireless communication controller 515 enables the vacuum pump 10 to communicate with an external device 705 (see, e.g., FIG. 7). The radio antenna and transceiver 615 operate together to send and receive wireless messages to and from the external device 705 and the processor 600. The memory 605 can store instructions to be implemented by the processor 600 and/or may store data related to communications between the vacuum pump 10 and the external device 705 or the like. The RTC 610 can increment and keep time independently of the other device components. The RTC 610 can receive power from the battery pack 50 when the battery pack 50 is connected to the vacuum pump 10. The processor 600 for the wireless communication controller 515 controls wireless communications between the vacuum pump 10 and the external device 705. For example, the processor 600 associated with the wireless communication controller 515 buffers incoming and/or outgoing data, communicates with the electronic control unit 34, and determines the communication protocol and/or settings to use in wireless communications. The communication via the wireless communication controller 515 can be encrypted to protect the data exchanged between the vacuum pump 10 and the external device 705 from third parties.

In the illustrated embodiment, the wireless communication controller 515 is a Bluetooth^{®} controller. The Bluetooth^{®} controller communicates with the external device 705 employing the Bluetooth ^{®} protocol. Therefore, in the illustrated embodiment, the external device 705 and the vacuum pump 10 are within a communication range (i.e., in proximity) of each other while they exchange data. In other embodiments, the wireless communication controller 515 communicates using other protocols (e.g., Wi-Fi, ZigBee, a proprietary protocol, etc.) over different types of wireless networks. For example, the wireless communication controller 515 may be configured to communicate via Wi-Fi through a wide area network such as the Internet or a local area network, or to communicate through a piconet (e.g., using infrared or NFC communications).

In some embodiments, the network is a cellular network, such as, for example, a Global System for Mobile Communications ("GSM") network, a General Packet Radio Service ("GPRS") network, a Code Division Multiple Access ("CDMA") network, an Evolution-Data Optimized ("EV-DO") network, an Enhanced Data Rates for GSM Evolution ("EDGE") network, a 3GSM network, a 4GSM network, a 4G LTE network, 5G New Radio, a Digital Enhanced Cordless Telecommunications ("DECT") network, a Digital AMPS ("IS-136/TDMA") network, or an Integrated Digital Enhanced Network ("iDEN") network, etc.

The wireless communication controller 515 is configured to receive data from the electronic control unit 34 and relay the information to the external device 705 via the antenna and transceiver 615. In a similar manner, the wireless communication controller 515 is configured to receive information (e.g., configuration and programming information) from the external device 705 via the antenna and transceiver 615 and relay the information to the electronic control unit 34.

FIG. 7 illustrates a communication system 700. The communication system 700 includes at least one of the vacuum pump 10 (illustrated as a power tool device) and the external device 705. The vacuum pump 10 and the external device 705 can communicate wirelessly while they are within a communication range of each other. The vacuum pump 10 may communicate a status, operation statistics, sensor data, stored usage information, and the like associated with the vacuum pump 10.

More specifically, the vacuum pump 10 can monitor, log, and/or communicate various operational parameters. The external device 705 can also transmit data to the vacuum pump 10 for pump configuration, firmware updates, or to send commands. The external device 705 also allows a user to set operational parameters, safety parameters, select tool modes, and the like for the vacuum pump 10.

The external device 705 is, for example, a smart phone (as illustrated), a laptop computer, a tablet computer, a personal digital assistant ("PDA"), or another electronic device capable of communicating wirelessly with the vacuum pump 10 and providing the user interface 800 (see, e.g., FIG. 8). The external device 705 provides the user interface 800 and allows a user to access and interact with the vacuum pump 10. The external device 705 can receive user inputs to determine operational parameters, enable or disable features, and the like. The user interface 800 of the external device 705 provides an easy-to-use interface for the user to control and customize operation of the vacuum pump 10.

In addition, as shown in FIG. 7, the external device 705 can also share the operational data obtained from the vacuum pump 10 with a remote server 725 connected through a network 715. The remote server 725 may be used to store the operational data obtained from the external device 705, provide additional functionality and services to the user, or a combination thereof. In some embodiments, storing the information on the remote server 725 allows a user to access the information from a plurality of different locations. In some embodiments, the remote server 725 collects information from various users regarding their power tool devices and provide statistics or statistical measures to the user based on information obtained from the different power tools. The network 715 may include various networking elements (routers 710, hubs, switches, cellular towers 720, wired connections, wireless connections, etc.) for connecting to, for example, the Internet, a cellular data network, a local network, or a combination thereof, as previously described. In some embodiments, the vacuum pump 10 is configured to communicate directly with the server 725 through an additional wireless interface or with the same wireless interface that the vacuum pump 10 uses to communicate with the external device 705.

FIG. 8 illustrates the user interface 800 for the vacuum pump 10. In some embodiments, the user interface 800 is included in the external device 705. The user interface 800 includes a plurality of graphical user interface elements, such as, a power control input 805, a first operating mode input 810, a second operating mode input 815, and a user selection mode input 820. The power control input 805 is configured to enable a user to activate and deactivate (e.g., turn ON and OFF) the vacuum pump 10. The first operating mode input 810 is configured to enable a user to control performance of the vacuum pump 10 according to a first set of operating parameters. For example, the first operating mode input 810 provides operating parameters to reduce pump speed of the vacuum pump 10 based on a determination that a voltage of the battery pack 50 has reached a set threshold. In some embodiments the first operating mode input 810 is configured to control operation of the vacuum pump 10 into a "boost" or high-power mode of operation. The second operating mode input 815 is configured to enable a user to control performance of the vacuum pump 10 according to a second set of operating parameters. For example, the second operating mode input 815 provides operating parameters to reduce pump speed of the vacuum pump 10 based on a determination that a timer associated with the second operating mode has elapsed and/or an atmospheric pressure of the vacuum pump 10 has reached a set threshold. In some embodiments the second operating mode input 815 is configured to control operation of the vacuum pump 10 into an "eco" or economy mode of operation. The user selection mode input 820 is configured to enable a user to control performance of the vacuum pump 10 according to a set of operating parameters provided by the user. For example, the user selection mode input 820 provides operating parameters to adjust pump speed of the vacuum pump 10 based on a user selection of one of multiple operating speeds of the vacuum pump 10.

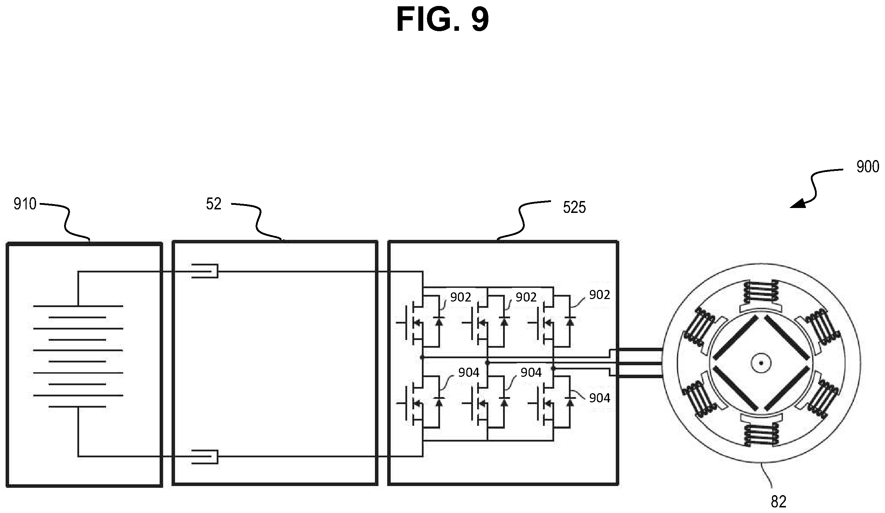

FIG. 9 illustrates a circuit diagram 900 of the FET switching module 525. The FET switching module 525 includes a number of high side power switching elements 902 and a number of low side power switching elements 904. The electronic control unit 34 provides the control signals to control the high side FETs 902 and the low side FETs 904 to drive the motor 82 based on the motor feedback information and user controls, as described above. For example, in response to detecting activation of the power switch 56, the electronic control unit 34 provides the control signals to selectively enable and disable the FETs 902 and 904 (e.g., sequentially, in pairs) resulting in power from the power source 910 (e.g., battery pack 50) to be selectively applied to stator coils of the motor 82 to cause rotation of a rotor. More particularly, to drive the motor 82, the electronic control unit 34 enables a first high side FET 902 and first low side FET 904 pair (e.g., by providing a voltage at a gate terminal of the FETs) for a first period of time. In response to determining that the rotor of the motor 82 has rotated based on a pulse from the sensing circuits 505, the electronic control unit 34 disables the first FET pair, and enables a second high side FET 902 and a second low side FET 904. In response to determining that the rotor of the motor 82 has rotated based on pulse(s) from the sensing circuits 505, the electronic control unit 34 disables the second FET pair, and enables a third high side FET 902 and a third low side FET 904. This sequence of cyclically enabling pairs of high side FET 902 and low side FET 904 repeats to drive the motor 82. Further, in some embodiments, the control signals include pulse width modulated (PWM) signals having a duty cycle that is set based on the power switch 56, to thereby control the speed or torque of the motor 82.

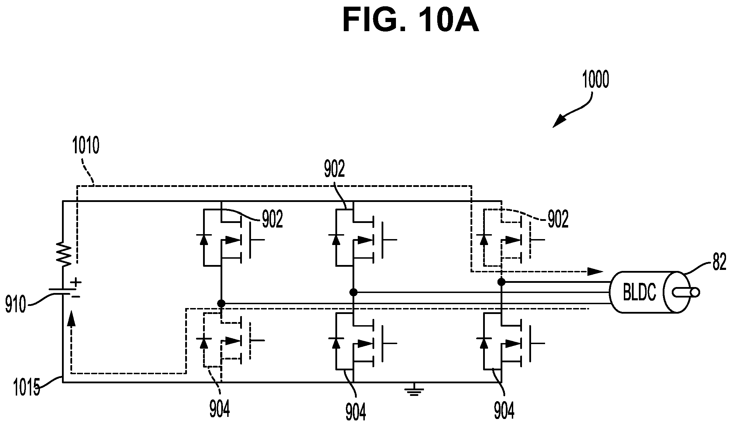

FIG. 10A illustrates a current flow diagram 1000 of the FET switching module 525 for using current to determine battery pack impedance. The FET switching module 525 includes the plurality of high side power switching elements 902 and the plurality of low side power switching elements 904, as described above. For example, in response to detecting activation of the power switch 56, the electronic control unit 34 provides the control signals to selectively enable and disable the FETs 902 and 904 (e.g., sequentially, in pairs) resulting in power being provided from the power source (e.g., battery pack 50). Current 1010 travels from the power source 910 through one of the high side power switching elements 902 to stator coils of the motor 82. The current 1010 then travels from the motor 82 to one of the low side power switching elements 904 before completing a path of connection 1015 of the power source 910.

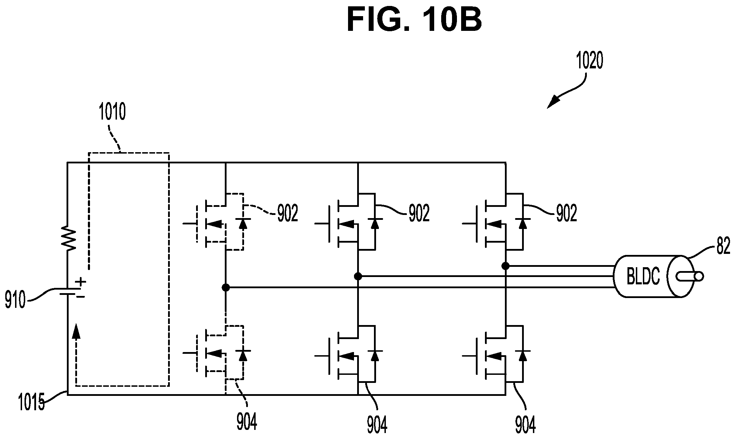

FIG. 10B illustrates another embodiment of a current flow diagram 1020 of the FET switching module 525 for using current to determine battery pack impedance. The FET switching module 525 includes the plurality of high side power switching elements 902 and the plurality of low side power switching elements 904, as described above. For example, in response to detecting activation of the power switch 56, the electronic control unit 34 provides the control signals to selectively enable and disable the FETs 902 and 904 (e.g., sequentially, in pairs) resulting in power being provided from the power source 910 (e.g., the battery pack 50). Current 1010 travels from the power source 910 through one high side power switching elements 902, to one low side power switching elements 904. The current 1010 closes the circuit by then returning to the power source 910. This reduced current 1010 path only travels through two switching FETs and completes a shorter portion of the path of connection 1015 of the power source 910. In some embodiments, one or more high side power switching elements 902 and/or one or more low side power switching elements 904 are enabled at the same time. Such control may decrease the overall resistance of the system and enable higher current flow and distributing the load of the system through the FETs 902 and 904 to reduce FET 902 and 904 burnup.

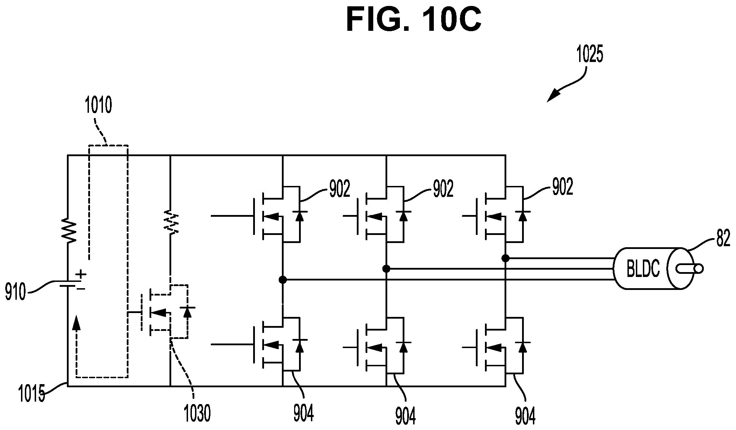

FIG. 10C illustrates another embodiment of a current flow diagram 1025 of the FET switching module 525 for using current to determine battery pack impedance. In this embodiment, an additional switching module 1030 is connected to the path of connection 1015. In addition to the additional switching module 1030, an additional resistor is connected to the path of connection 1015. For example, in response to detecting activation of the power switch 56, the electronic control unit 34 provides the control signals to selectively enable and disable the switching module 1030 resulting in power being provided from the power source 910 (e.g., the battery pack 50). Current 1010 travels from the power source 910 through the additional resistor, then through the additional switching module 1030. The current 1010 only travels through the additional resistor and the additional switching module 1030 then returns to the power source 910 to close the circuit. In other embodiments, an inductor can be used for similar purposes as the additional resistor. Additionally, other circuitry configurations may be configured in such a way that other components can be used (e.g., a capacitor).

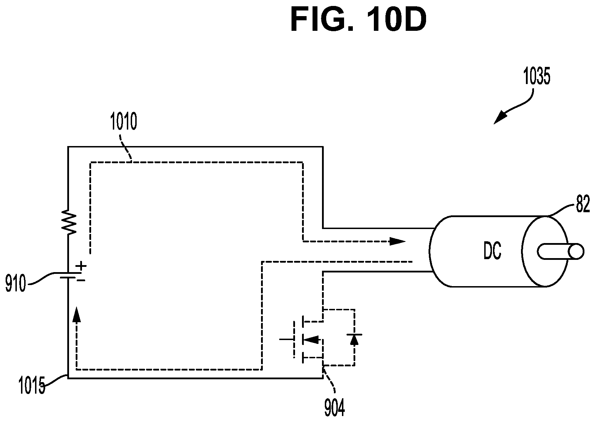

FIG. 10D illustrates yet another embodiment of a current flow diagram 1035 of the FET switching module 525 for using current to determine battery pack impedance. In this embodiment, only one power switching module 904 is used. For example, in response to detecting activation of the power switch 56, the electronic control unit 34 provides the control signals to selectively enable and disable the power switching element 904 resulting in power being provided from the power source 910 (e.g., the battery pack 50). Current 1010 travels from the power source 910 to the motor 82 (e.g., a brushed motor), then to the power switching element 904 before closing the path of connection 1015.

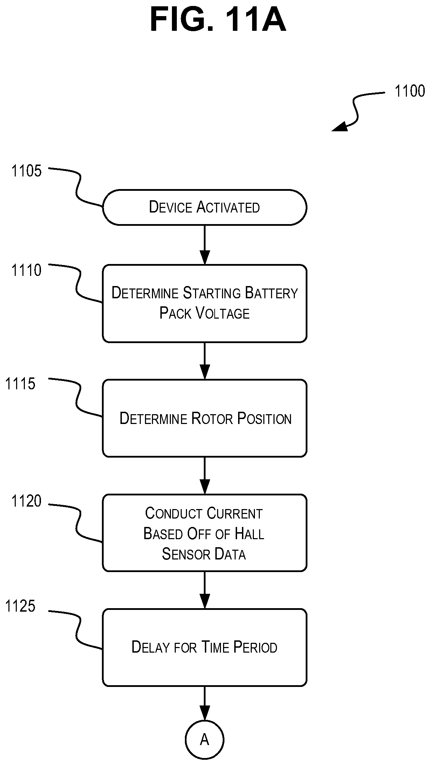

FIG. 11A illustrates a method 1100 executed by the electronic control unit 34 of the vacuum pump 10. The vacuum pump 10 is activated (STEP 1105) to initialize the method 1100 by the electronic control unit 34. For example, the vacuum pump 10 may be activated by detecting activation of the power switch 56, which causes the battery pack 50 to deliver power to the vacuum pump 10. The electronic control unit 34 receives or measures the battery pack voltage from the battery pack 50, and the electronic control unit 34 determines or calculates a starting battery pack voltage (STEP 1110). The vacuum pump 10 then receives one or more signals from the plurality of sensing circuits 505 (e.g., Hall Effect sensors) related to a rotational position of the motor 82 (i.e., the rotor). Data corresponding to the one or more signals are stored within the memory 535 for determining rotor position (STEP 1115). In some embodiments, the power tool does not include Hall Effect sensors. Instead, the power tool uses back-emf to determine the position of the motor. In other embodiments, an inrush technique by enabling the high side switching elements 902 and the low side switching elements 904 can derive the position of the motor (e.g., through back-emf, Hall transition, etc.). In other embodiments, the motor 82 position may be ascertained by conducting multiple quick inrush pulses and comparing relative impedances. In other embodiments, the position of the motor is not used in the case where the inductance is similar regardless of motor rotation.

In some embodiments, STEPS 1115 and 1120 may be optional. If the location of the rotor is known, the current may flow through a path with ideal inductance. Higher inductance corresponds to a slower rise in current. This allows more time for the rise in current, which helps to take the measurement. If there is a fixed time period delay (described in further detail below), it also avoids draining too much current that might damage electrical components.

Using the data received from the aforementioned sensing circuits 505, the vacuum pump 10 initiates power to one or more high side power switches modules 902, and one or more low side switching modules 904, which consequently conducts current through the motor 82 (STEP 1120). A delay is then instituted to allow for a flow of current through the system (STEP 1125). The delay allows for the current to rise to a level that can be reliably read with sufficient resolution. Without the delay, there may not be a significant enough change in voltage or current. The length of the delay prevents burning up an electrical component (e.g., an FET 902 and 904), as well as not allowing the motor to over significantly rotate. In some embodiments, the method is delayed approximately 40µs. In other embodiments, longer or shorter delays can be implemented to avoid transient voltage or current spikes. In some embodiments, one of a hard busy wait is used. In some embodiments, a measurement includes multiple samples (e.g., of current and voltage).

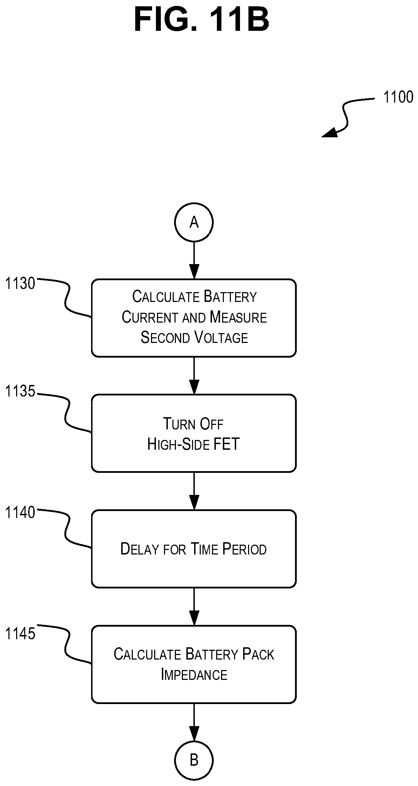

FIG. 11B illustrates a continuation of the method 1100 executed by the electronic control unit 34. After implementing a delay at STEP 1125, the electronic control unit 34 is configured to sample a current sense input to an analog-to-digital converter ("ADC") and receives or measures a second voltage (e.g., sampling a voltage sense input to an ADC). In some embodiments, multiple samples are taken within a measurement. The electronic control unit 34 uses the sampled current sense input to then calculate the current of the battery pack 50, I_{bat}, and the second voltage measurement, V_{end} (STEP 1130). The electronic control unit 34 is then configured to turn off the low side power switches 904 to allow the high side power switches 902 to freewheel current (STEP 1135). Another delay is used to allow the high side power switches 902 to freewheel current for an amount of time (STEP 1140). In some embodiments, the method is delayed approximately 100 µs. In other embodiments, longer or shorter delays can be implemented. After the second delay of the method 1100, the high side power switching 902 is turned off.

Using the starting battery voltage from STEP 1110, the second battery voltage from STEP 1130, and the calculated current of the battery pack 50 from STEP 1130, the electronic control unit 34 is configured to determine the impedance of the battery pack 50. The impedance of the battery pack 50 can be calculated by the electronic control unit 34 using, for example, the following equation: ${Z}_{pack} = \frac{{V}_{start} - {V}_{end}}{{I}_{bat}}$

Although EQN. 1 provides one example of how battery pack impedance can be determined, other techniques for determining battery pack impedance can also be used.

In another embodiment of estimating impedance of the battery pack, the rate of voltage drop and rate of current increase can be used in relation of the inductance of the system. The voltage drop is measured at least twice, and assumes a fixed inductance. In another embodiment of estimating impedance of the battery pack, the measurement of current alone may also be used to estimate general impedance of the battery pack. In another embodiment of estimating impedance of the battery pack, the integration of measured current over time may be used to find an estimation of the impedance of the battery pack. Similarly, the integration of voltage over time may be used to find an estimation of the impedance of the battery pack. Similarly, the derivative of the rising current and/or the derivative of the falling voltage may also be used to find an estimation of the impedance of the battery pack.

In another embodiment of estimating impedance of the battery pack, during an inrush current technique, voltage and current samples are measured to perform a slope calculation to find impedance. The slope calculation can feed into another algorithm (e.g., a neutral net, filter functions, etc.) to derive multiple aspects of the impedance (e.g., resistance, capacitance, inductive loading, etc.). Additionally, the inrush technique could be used with multiple inrush spikes and the results can be combined for a more precise output.

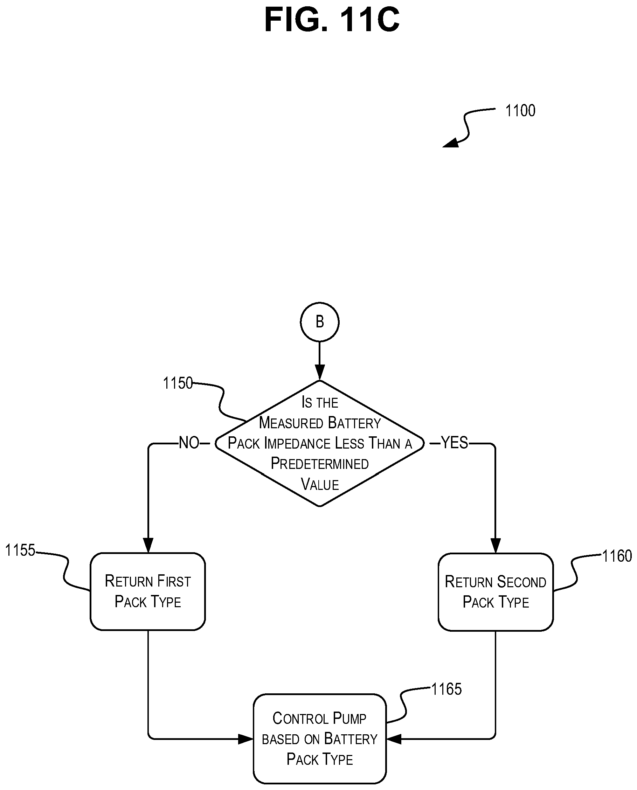

FIG. 11C is a continuation of method 1100. If, at STEP 1150, the calculated impedance is greater than or equal to a certain predetermined value (e.g., a value of 50 to 80 milli-Ohms), the electronic control unit 34 is configured to determine that the battery pack 50 is a particular type of battery pack (STEP 1155). The electronic control unit 34 then proceeds to control the vacuum pump 10 (e.g., to control current drawn from the battery pack 50) based on the determination of the particular type of battery pack and the calculated impedance. If, at STEP 1150, the calculated impedance is less than the certain predetermined value, the electronic control unit 34 is configured to determine that the battery pack 50 is a second particular type of battery pack (STEP 1160). The electronic control unit 34 then proceeds to control the vacuum pump 10 (e.g., to control current drawn from the battery pack 50) based on the determination of the second particular type of battery pack and/or the calculated impedance. In other embodiments, any number of different types of battery packs can be identified (e.g., three or more, between three and 20, etc.). In some embodiments, multiple impedance thresholds are included for determining the type of battery pack. In some embodiments, the impedance is a continuous parameter that is used to identify the type of battery pack (e.g., using a lookup table). In another embodiment, the voltage and/or current of the system may be measured by the battery pack. In other embodiments, the voltage and/or current measurements may be communicated to the tool (e.g., via digital or analog interface). In other embodiments, the battery pack may self-calculate its own impedance. The battery pack may communicate the self-calculated impedance of the battery pack to the power tool. In another embodiment, the power tool may calculate the impedance of the battery pack, then communicate the result of the calculation to the battery pack.

In some embodiments, the determination of the type of the battery pack may be probabilistic. In some embodiments, the type of the battery pack may be found by a thermal measurement. The thermal measurement of the battery pack may be found using a temperature sensor (e.g., a thermistor, thermocouple, etc.). Because impedance changes with temperature, the thermal measurement can be used to identify the most probable battery pack type.

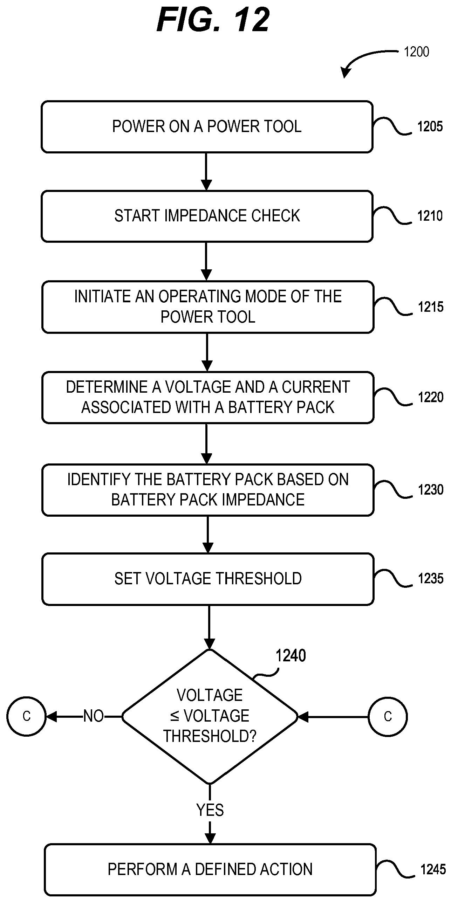

FIG. 12 illustrates a method 1200 executed by the electronic control unit 34 of the vacuum pump 10. The vacuum pump 10 is powered on (STEP 1205) to initialize the method 1200 by the electronic control unit 34. For example, the vacuum pump 10 may be activated by detecting activation of the power switch 56, which causes the battery pack 50 to deliver power to the vacuum pump 10. The electronic control unit 34 then initiates an impedance check to determine an impedance of the battery pack 50 (e.g., using one of the methods described above) (STEP 1210). For example, the electronic control unit 34 receives a user selection of an operating mode via the control panel 54. The electronic control unit 34 then proceeds to control the vacuum pump 10 based on the operating parameters of the user selection (STEP 1215). The electronic control unit 34 receives or measures the battery pack 50 voltage from the battery pack 50, and the electronic control unit 34 determines or calculates a starting battery pack voltage. The electronic control unit 34 then receives one or more signals (e.g., current and voltage measurements associated with the battery pack 50) from the sensing circuits 505 (STEP 1220). In some embodiments, the electronic control unit 34 logs data corresponding to the one or more signals in the memory 535 for determining a battery pack impedance and a battery pack type of the battery pack 50. The electronic control unit 34 then identifies the battery pack 50 based on an impedance of the battery pack using one of the methods described above (STEP 1220). In addition to, or alternatively, in some embodiments, the electronic control unit 34 uses the data (e.g., energy discharged, energy discharge time, battery pack voltage, current) logged in the memory 535 to determine a battery type. Using the starting battery voltage from STEP 1210, the starting battery pack voltage and the current of the battery pack from STEP 1220 the electronic control unit 34 is configured to determine the energy discharged by the battery pack 50. The electronic control unit 34 sets a voltage threshold based on the battery pack type of the battery pack 50 (STEP 1235). For example, the electronic control unit 34 sets a low battery alert based on a determined battery pack type of the battery pack 50 connected to the vacuum pump 10.

The electronic control unit 34 compares the battery pack voltage to the voltage threshold (STEP 1240). If, at STEP 1240, the battery pack voltage is greater than a voltage threshold of the battery pack 50, the electronic control unit 34 is configured to continue to monitor the voltage of the battery pack 50 (STEP 1240). The electronic control unit 34 then proceeds to control the vacuum pump 10 (e.g., to control current drawn from the battery pack 50) based on a first set of operating parameters of the selected operating mode. If, at STEP 1240, the battery pack voltage is less than or equal to a voltage threshold of the battery pack 50, the electronic control unit 34 is configured to perform a defined action (STEP 1245). The defined action can include the electronic control unit 34 proceeding to control the vacuum pump 10 (e.g., to control current drawn from the battery pack 50) based on a second set of operating parameters of the selected operating mode. In some embodiments the electronic control unit 34 reduces the speed of the motor 82 to decrease the discharge rate of the battery pack 50 and reduce airflow, which extends runtime of the vacuum pump 10, while maintaining performance conditions provided by the vacuum pump 10. In some implementations, the electronic control unit 34 activates the indicators 510. For example, one or more LEDs can be turned on or a buzzer can be triggered to indicate a battery pack state of charge or remaining run time.

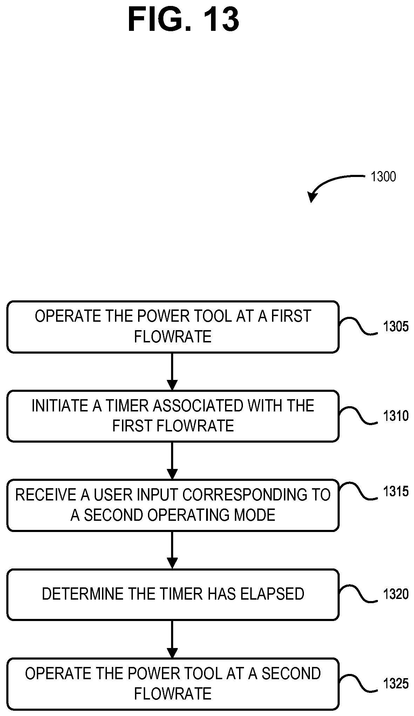

FIG. 13 illustrates a method 1300 for controlling the vacuum pump 10 executed by the electronic control unit 34. The vacuum pump 10 is powered on to initialize the method 1300 by the electronic control unit 34. For example, the vacuum pump 10 may be activated by receiving a signal from the control panel 54 associated with a user selection to power on the vacuum pump 10, which causes the battery pack 50 to deliver power to the vacuum pump 10. In another example, the signal is associated with a mode of operation set using the user interface 800, as shown in FIG. 8. The electronic control unit 34 controls the current the battery pack 50 provides to the motor assembly 30 that drives the pump assembly 42 that removes or evacuates material from the external system 46 at first flowrate (STEP 1305). For example, the first flowrate may be associated with a default flowrate of the vacuum pump 10. The electronic control unit 34 initiates a timer associated with a start time of the pump assembly 42 and/or the first flowrate (STEP 1310).

The electronic control unit 34 receives a signal associated with a user selection from the control panel 54 (STEP 1315). In some embodiments, STEP 1315 is optional. The electronic control unit 34 receives a signal that indicates a defined time period from initiation of the start time has elapsed (STEP 1320). In some embodiments, the timer in STEP 1310 is not initiated until after the user selection from the control panel 54 is received. The electronic control unit 34 is configured to control the vacuum pump 10 (e.g., to control the speed of the motor 82) based on operating parameters (e.g., flowrate) associated with the user selection of a second operating mode (STEP 1325). For example, the electronic control unit 34 drives the pump assembly 42 at a first flowrate, such as, for example a default flow rate of five (5) cubic feet per minute (CFM) (e.g., corresponding to 2,500 motor rotations per minute ["RPM"]. In this example, after the electronic control unit 34 receives an operation mode selection, the electronic control unit 34 can reduce or increase a flowrate of the vacuum pump 10 based on the operation mode selection. In an "eco" or economy mode, the flowrate of the vacuum pump 10 is reduced (e.g., from 5 CFM to 3 CFM). As indicated above, the eco mode can be entered after an amount of time (e.g., a predetermined amount of time) has elapsed or immediately upon receiving a corresponding user input (e.g., from user interface 800). In a "boost" or high-power mode, the flowrate of the vacuum pump 10 is increased (e.g., from 5 CFM to 7 CFM). As indicated above, the boost mode can be entered after an amount of time (e.g., a predetermined amount of time) has elapsed or immediately upon receiving a corresponding user input (e.g., from user interface 800). In some embodiments, the user interface 800 is used to select specific values for either the RPM of the motor 82 or specific values for CFM. In some embodiments, the defined time period from initiation of the start time has elapsed, and then the electronic control unit 34 receives a signal associated with the second operating mode, the electronic control unit 34 immediately reduces (eco mode) or increases (boost mode) a flowrate of the vacuum pump 10.

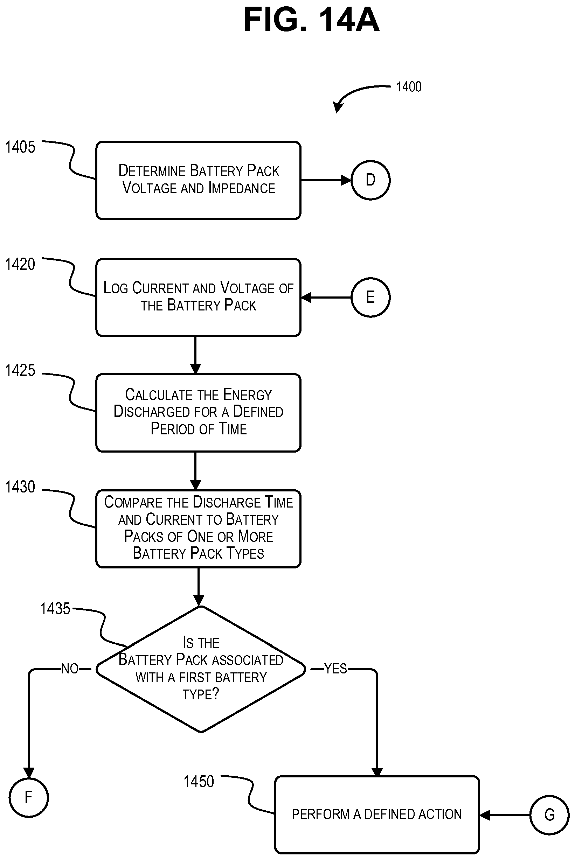

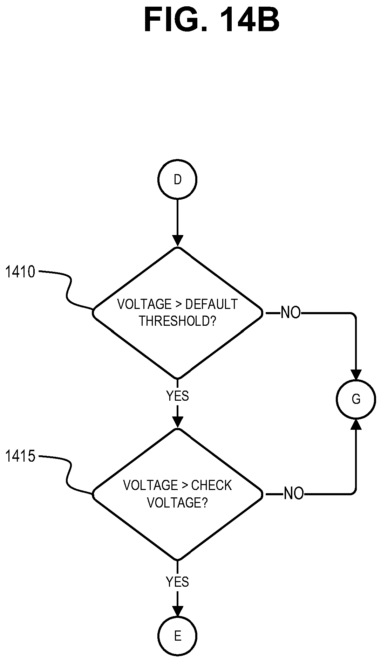

FIG. 14A illustrates a method 1400 for controlling a low battery notification of the vacuum pump 10 executed by the electronic control unit 34. The vacuum pump 10 is powered on to initialize the method 1400 by the electronic control unit 34. The electronic control unit 34 determines a battery pack voltage and an impedance of the battery pack 50 using one of the methods described above (STEP 1405). In some embodiments, the electronic control unit 34 determines the current the battery pack 50 provides to the vacuum pump 10. The method 1400 then proceeds to FIG. 14B. FIG. 14B is a continuation of the method 1400. Using the determined battery pack voltage from STEP 1405, the electronic control unit 34 determines whether the determined battery pack voltage is greater than a default threshold voltage (STEP 1410). If, at STEP 1410, the determined battery pack voltage is less than or equal to the default threshold voltage, then electronic control unit 34 proceeds to control the indicators 510 of the vacuum pump 10 (STEP 1450) (see FIG. 14A). For example, the default threshold voltage is associated with an initial startup voltage of the battery pack 50 (e.g., a near dead battery) and the electronic control unit 34 enables the indicators 510 to notify a user of the status of the battery pack 50. If, at STEP 1410, the determined battery pack voltage is greater than the default threshold voltage, then electronic control unit 34 proceeds to determine whether the battery pack 50 provides a measurable voltage, such as, for example a check voltage (STEP 1415).

If, at STEP 1415, the determined battery pack voltage is less than or equal to the check threshold, then electronic control unit 34 proceeds to control the indicators 510 of the vacuum pump 10 (STEP 1450) (see FIG. 14A). For example, the check voltage is associated with a voltage of the battery pack 50 (e.g., a low battery) that the sensors 505 are capable of sensing for an accurate measurement, and the electronic control unit 34 enables the indicators 510 to notify a user of the status of the battery pack 50 after, for example, expiration of a time threshold (e.g., eight minutes of discharge for a 12.0AH battery pack). If, at STEP 1415, the determined battery pack voltage is greater than the check threshold, the electronic control unit 34 is configured to log the battery pack voltage and the current of the battery pack 50 in, for example, the memory 535 (STEP 1420) (see FIG. 14A).

Using the battery voltage and current from STEP 1420, the electronic control unit 34 is configured to determine an amount of energy discharged from the battery pack 50 over a defined time period (STEP 1425). The amount of energy discharged from the battery pack 50 can be calculated by the electronic control unit 34. In some embodiments of estimating the discharged energy of the battery pack 50, the electronic control unit 34 determines a moving average of the current and voltage of the battery pack 50, and uses a Riemann sum to integrate for a value of energy to change in voltage. In another embodiment of estimating the discharged energy of the battery pack 50, the measurement of current or voltage alone may also be used to estimate the discharged energy of the battery pack 50.

Using logged data from STEP 1420 and the discharged energy from STEP 1425, the electronic control unit 34 compares the logged data in the memory 535 to profiles of identified battery packs in the memory 535 (STEP 1430). The logged data includes, for example, a time related to a voltage drop of the battery pack 50, the average current of the battery pack 50 over the time related to the voltage drop (e.g., from 16.5V to 16.0V), etc. In some embodiments, in addition to the logged data, the electronic control unit 34 compares the impedance of the battery pack 50 and the impedance of the profiles of identified battery packs in the memory 535. For example, larger battery packs output greater amounts of energy over a smaller change in voltage than smaller battery packs.

If, at STEP 1435, the discharged energy of the battery pack 50 is approximately equivalent to a discharged energy value in a profile of a first battery type (e.g., 6.0 Ampere hour [Ah] battery pack), the electronic control unit 34 is configured to determine that the battery pack 50 is a battery of the first battery type. The electronic control unit 34 then proceeds to control the indicators 510 of the vacuum pump 10 to indicate a state of charge of the battery pack 50 based on the first battery type and the battery pack voltage of the battery pack 50 (STEP 1450). In some embodiments, a buzzer can be sounded or the indicators 510 can be activated to indicate that the battery pack 50 has reached a low battery level.

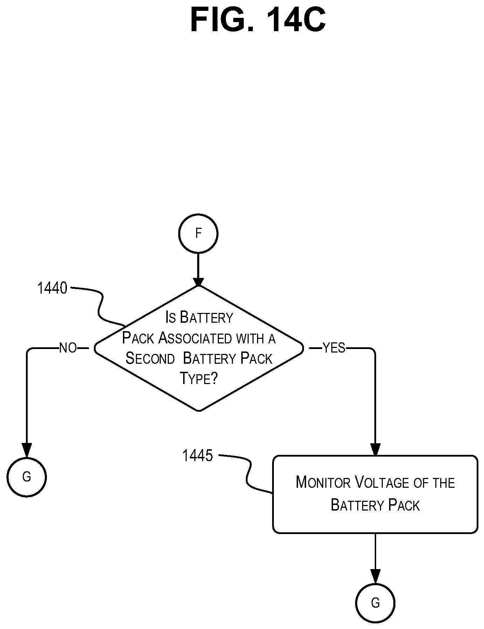

FIG. 14C is a continuation of the method 1400. If, at STEP 1435, the electronic control unit 34 determines that the battery pack 50 is not a battery of the first battery type, the electronic control unit 34 is configured to determine whether the battery pack 50 is a battery of a second battery type (STEP 1440). If, at STEP 1440, the discharged energy of the battery pack 50 is approximately equivalent to a discharged energy value in a profile of the second battery type (e.g., 12.0 Ampere hour [Ah] battery pack), the electronic control unit 34 is configured to determine that the battery pack 50 is a battery of the second battery type (STEP 1440). The electronic control unit 34 then proceeds to control the indicators 510 of the vacuum pump 10 to indicate a state of charge of the battery pack 50 based on the second battery type and the battery pack voltage of the battery pack 50 while monitoring the voltage of the battery pack 50 (STEP 1445). In some embodiments, the electronic control unit waits until after, for example, expiration of the time threshold (e.g., eight minutes of discharge for a 12.0AH battery pack). For example, the electronic controller 34 monitors the voltage of the battery pack 50 (e.g., waiting until the voltage reaches the set voltage threshold to enable a buzzer or indicators 510). If, at STEP 1440, the discharged energy of the battery pack 50 is not approximately equivalent to a discharged energy value in a profile of the second battery type (e.g., 12.0 Ampere hour [Ah] battery pack), the electronic control unit 34 is configured to control the indicators 510 of the vacuum pump 10 (e.g., enable a buzzer based on the battery pack voltage).

### REPRESENTATIVE FEATURES

Representative features are set out in the following clauses, which stand alone or may be combined, in any combination, with one or more features disclosed in the text and/or drawings of the specification.
1. A battery pack powered device comprising:
   a housing including a battery pack interface configured to receive a battery pack;
   a first sensing circuit configured to detect a battery pack voltage of the battery pack;
   a second sensing circuit configured to detect a current from the battery pack; and
   a controller including a processor and a memory, the controller configured to:
      receive a first signal from the first sensing circuit related to the battery pack voltage,
      receive a second signal from the second sensing circuit related to the current from the battery pack,
      determine a battery pack impedance based on the battery pack voltage and the current from the battery pack,
      determine a battery pack type of the battery pack based on the battery pack impedance, and
      set a voltage threshold for the battery pack based on the battery pack type.
2. The battery pack powered device of clause 1, wherein the battery pack powered device is operable to:
   determine an amount of energy the battery pack discharges over a defined time period based on the battery pack voltage and the current from the battery pack,
   determine a change in voltage of the battery pack based on the battery pack voltage, and
   determine the battery pack type of the battery pack based on the battery pack impedance, the determined amount of energy, and the change in voltage.
3. The battery pack powered device of clause 2, wherein the battery pack powered device is operable to perform a defined action based on the battery pack type, the voltage threshold, and the battery pack voltage.
4. The battery pack powered device of clause 3, wherein the battery pack powered device is operable to:
   determine the battery pack voltage is less than or equal to the voltage threshold; and
   modify an operating mode of the battery pack powered device resulting in an increase in a discharge time of the battery pack.
5. The battery pack powered device of clause 3, wherein the battery pack powered device is operable to:
   receive a user input indicating a selection of an operating mode; and
   control the battery pack powered device based on the battery pack type and the battery pack voltage.
6. The battery pack powered device of clause 5, wherein the controller is further configured to:
   reduce an operating speed of the battery powered device based on the operating mode.
7. The battery pack powered device of clause 5, wherein the controller is further configured to:
   control the battery powered device at a first operating speed for a first defined time period based on the operating mode, and
   control the battery powered device at a second operating speed for a second defined time period based on the operating mode.
8. The battery pack powered device of any of clauses 1-7, wherein the controller is further configured to:
   control operation of one or more indicators of the battery powered device based on the battery pack type that is determined and the battery pack voltage.
9. A method for operating a battery pack powered device, the method comprising:
   receiving, by a controller from a first sensing circuit, a first signal related to a battery pack voltage of a battery pack of the battery pack powered device;
   receiving, by the controller from a second sensing circuit, a second signal related to a current from the battery pack;
   determining, by the controller, a battery pack impedance based on the battery pack voltage and the current from the battery pack;
   determining, by the controller, a battery pack type of the battery pack based on the battery pack impedance; and
   setting, by the controller, a voltage threshold for the battery pack based on the battery pack type.
10. The method of clause 9, further comprising:
   determining, by the controller, an amount of energy the battery pack discharges over a defined time period based on the battery pack voltage and the current from the battery pack;
   determining, by the controller, a change in voltage of the battery pack based on the battery pack voltage; and
   determining, by the controller, the battery pack type of the battery pack based on the battery pack impedance, the determined amount of energy, and the change in voltage.
11. The method of clause 10, further comprising:
   performing, by the controller, a defined action based on the battery pack type, the voltage threshold, and the battery pack voltage.
12. The method of clause 11, further comprising:
   determining, by the controller, the battery pack voltage is less than or equal to the voltage threshold; and
   modifying, by the controller, an operating mode of the battery pack powered device resulting in an increase in a discharge time of the battery pack.
13. The method of clause 11, further comprising:
   receiving, by the controller, a user input indicating a selection of an operating mode; and
   controlling, by the controller, the battery pack powered device based on the battery pack type and the battery pack voltage.
14. The method of clause 13, further comprising:
   reducing, by the controller, an operating speed of the battery powered device based on the operating mode.
15. The method of clause 13, further comprising:
   controlling, by the controller, the battery powered device at a first operating speed for a first defined time period based on the operating mode; and
   controlling, by the controller, the battery powered device at a second operating speed for a second defined time period based on the operating mode.
16. The method of any of clauses 9-15, further comprising:
   controlling, by the controller, operation of one or more indicators of the battery powered device based on the battery pack type that is determined and the battery pack voltage.
17. A battery pack powered device comprising:
   the battery pack powered device configured to receive a battery pack; and
   a controller including a processor and a memory, the controller configured to:
      determine a battery pack impedance of the battery pack,
      determine a battery pack type of the battery pack based on the battery pack impedance, and
      set a voltage threshold for the battery pack based on the battery pack type.
18. The battery pack powered device of clause 17, wherein the battery pack powered device is operable to:
   determine a battery pack impedance of the battery pack based on a battery pack voltage of the battery pack.
19. The battery pack powered device of clause 17, wherein the battery pack powered device is operable to:
   determine a battery pack impedance of the battery pack based on current from the battery pack.
20. The battery pack powered device of any of clauses 17-19, wherein the battery pack powered device is operable to perform a defined action based on the battery pack type, the voltage threshold, and the battery pack voltage.
21. The battery pack powered device of any of clauses 17-20, wherein the battery pack powered device is operable to:
   modify, based on the battery pack voltage and the voltage threshold, an operating mode of the battery pack powered device resulting in a change in a discharge time of the battery pack.
22. The battery pack powered device of any of clauses 17-21, wherein the controller is further configured to:
   control operation of one or more indicators of the battery powered device based on the battery pack voltage.
23. A system comprising:
   a battery pack powered device that includes a battery pack;
   a first sensor configured to detect a battery pack voltage of the battery pack;
   a second sensor configured to detect a current from the battery pack;
   one or more indicators; and
   a controller communicably coupled to the battery pack powered device, the first sensor, and the second sensor, the controller including a processor and a memory, the controller configured to:
      receive a first signal from the first sensor representative of the battery pack voltage,
      receive a second signal from the second sensor representative of the current from the battery pack,
      determine an amount of energy the battery pack discharges over a defined time period based on at least one of the battery pack voltage and the current from the battery pack,
      determine a battery pack type of the battery pack based on the amount of energy the battery pack discharges over the defined time period and the current from the battery pack, and
      control operation of the one or more indicators based on a voltage threshold for the battery pack type that is determined and the battery pack voltage.
24. The system of claim 23, wherein the voltage threshold is at least one of a first voltage threshold and a second voltage threshold, wherein the first voltage threshold is greater than the second voltage threshold.
25. The system of clause 24, the controller is further configured to:
   determine whether the battery pack voltage exceeds the first voltage threshold, wherein the first voltage threshold is associated with an initial startup voltage of the battery pack.
26. The system of clause 24, the controller is further configured to:
   determine, in response to determining that the battery pack voltage exceeds the first voltage threshold, whether the battery pack voltage exceeds the second voltage threshold, wherein the second voltage threshold is associated with a voltage of the battery pack that the first sensor is capable of sensing for an accurate measurement.
27. The system of clause 24, the controller is further configured to:
   enable, in response to determining that the battery pack voltage exceeds the second voltage threshold, the one or more indicators to notify a user of a status of the battery pack after expiration of a defined discharge time of the battery pack based on the battery pack type that is determined.
28. The system of any of clauses 23-27, wherein, to determine the battery pack type of the battery pack based on the amount of energy the battery pack discharges over the defined time period and the current from the battery pack, the controller is further configured to:
   compare the amount of energy the battery pack discharges over the defined time period and the current from the battery pack to energy characteristics and current characteristics of one or more battery packs having a determined battery pack type, and
   determine whether the amount of energy the battery pack discharges over the defined time period and the current from the battery pack are within a threshold range of an energy discharge and current level of the one or more battery packs.

Thus, embodiments described herein provide, among other things, a vacuum pump that can determine an impedance of a battery pack, a discharged energy of the battery pack, and control the speed of a motor in the pump. Various features and advantages are set forth in the following claims.

## Claims

1. A system comprising:
a battery pack powered device that includes a battery pack;
a first sensor configured to detect a battery pack voltage of the battery pack;
a second sensor configured to detect a current from the battery pack;
one or more indicators; and
a controller communicably coupled to the battery pack powered device, the first sensor, and the second sensor, the controller including a processor and a memory, the controller configured to:
receive a first signal from the first sensor representative of the battery pack voltage,
receive a second signal from the second sensor representative of the current from the battery pack,
determine an amount of energy the battery pack discharges over a defined time period based on at least one of the battery pack voltage and the current from the battery pack,
determine a battery pack type of the battery pack based on the amount of energy the battery pack discharges over the defined time period and the current from the battery pack, and
control operation of the one or more indicators based on a voltage threshold for the battery pack type that is determined and the battery pack voltage.

2. The system of claim 1, wherein the voltage threshold is at least one of a first voltage threshold and a second voltage threshold, wherein the first voltage threshold is greater than the second voltage threshold.

3. The system of claim 2, the controller is further configured to:
determine whether the battery pack voltage exceeds the first voltage threshold, wherein the first voltage threshold is associated with an initial startup voltage of the battery pack.

4. The system of claim 2, the controller is further configured to:
determine, in response to determining that the battery pack voltage exceeds the first voltage threshold, whether the battery pack voltage exceeds the second voltage threshold, wherein the second voltage threshold is associated with a voltage of the battery pack that the first sensor is capable of sensing for an accurate measurement.

5. The system of claim 2, the controller is further configured to:
enable, in response to determining that the battery pack voltage exceeds the second voltage threshold, the one or more indicators to notify a user of a status of the battery pack after expiration of a defined discharge time of the battery pack based on the battery pack type that is determined.

6. The system of any of claims 1-5, wherein, to determine the battery pack type of the battery pack based on the amount of energy the battery pack discharges over the defined time period and the current from the battery pack, the controller is further configured to:
compare the amount of energy the battery pack discharges over the defined time period and the current from the battery pack to energy characteristics and current characteristics of one or more battery packs having a determined battery pack type, and
determine whether the amount of energy the battery pack discharges over the defined time period and the current from the battery pack are within a threshold range of an energy discharge and current level of the one or more battery packs.
